# EUROPEAN PATENT SPECIFICATION

(11) **EP 4 459 297 B1**
(45) Date of publication and mention of the grant of the patent: **09.09.2026**
(21) Application number: 24168141.0
(22) Date of filing: 02.04.2024
(51) Int. Cl.: G01R 21/00, H03K 17/22, H03K 19/003, H03K 19/0185

(54) **POWER LEVEL DETECTION CIRCUIT AND TWO-STAGE POWER DOMAIN CIRCUIT**
LEISTUNGSPEGELDETEKTIONSSCHALTUNG UND ZWEISTUFIGE LEISTUNGSDOMÄNENSCHALTUNG
CIRCUIT DE DÉTECTION DE NIVEAU DE PUISSANCE ET CIRCUIT DE DOMAINE DE PUISSANCE À DEUX ÉTAGES

(30) Priority: 02.05.2023 US 202363499497 P; 26.01.2024 US 202418423531
(43) Date of publication of application: 06.11.2024
(73) Proprietor: MEDIATEK INC., Hsinchu City 30078 (TW)
(72) Inventor: YANG, Jen-Hang, Hsinchu City (TW); WEI, Ying-Chun, Hsinchu City (TW)
(74) Representative: Hoefer & Partner Patentanwälte mbB

(56) References cited:
- US-A1- 2005 035 796
- US-A1- 2014 035 634
- US-A1- 2015 244 371
- US-A1- 2020 103 957
- US-A1- 2021 294 410
- US-A1- 2022 043 469
- US-A1- 2022 278 684

## Description

### CROSS REFERENCE TO RELATED APPLICATIONS

This application claims the benefit of U.S. Provisional Application No. 63/499, 497, filed May 2, 2023.

### BACKGROUND OF THE INVENTION

### Field of the Invention

The invention relates to a power level detection circuit, and in particular to a power level detection circuit for circuits in different power domains. More particularly, the present invention relates to a power level detection circuit according to the pre-characterizing part of independent claim 1 and to a corresponding two-stage power domain circuit. Such a power level detection circuit is shown in document US 2022/0278684 A.

### Description of the Related Art

In a circuit with two power domains, a first stage circuit in a first power domain generates a signal at an output terminal of the first power domain and provides the generated signal to a second stage circuit in a second power domain. When the level of the supply voltage of the second power domain has been on a predetermined supply level (that is, the level of the supply voltage of the second power domain is on a predetermined high level) but the level of the supply voltage of the first power domain is still on a low level, the first stage circuit does not operate, and the output terminal is in an unknown state. The output terminal of the first stage circuit may induce high crowbar currents in the second stage circuit.

Document US 2022/0043469 A1 discloses a power detection circuit for detecting powering down of a voltage domain in an integrated circuit. The power detection circuit is placed in or near the voltage domain in the integrated circuit to provide power detection on the integrated circuit. The power detection circuit detects powering down of the voltage domain to provide an isolation enable signal to another voltage domain that interfaces with the powering down voltage domain. The isolation enable signal may be used by an isolation cell coupled to the non-powering down voltage domain to prevent corrupted logic being received from the powering down voltage domain.

Document US 2014/0035634 A1 discloses integrated circuits (ICs) comprising circuits configured to generate a power on reset (POR) pulse. An IC comprises a power supply sense circuit configured to generate a sense signal in response to a transition of a power supply signal from a first level to a second level, and a pulse generation circuit coupled with the power supply sense circuit. The pulse generation circuit is configured to generate a POR pulse of a threshold duration based on the sense signal. The IC further includes a reset generation circuit coupled with the pulse generation circuit to receive the POR pulse. The reset generation circuit is configured to generate a reset pulse based on the POR signal and of at least one control signal, where the reset pulse is configured to be utilized to perform a reset of one or more elements of the integrated circuit.

Document US 2015/0244371 A1 discloses a level conversion circuit for generating an output signal having one of a higher output level and a lower output level in response to an input signal having one of a higher input level and a lower input level. The level conversion circuit has input circuitry which, in response to a transition of the input signal between the higher and lower input levels, output a rising transition of a temporary output signal on the output line towards the higher input level. Output control circuitry detects the rising transition of the temporary output signal and pulls the output signal to the higher output level. This arrangement allows for fast level conversion without a DC leakage path.

Document US 2020/0103957 A1 discloses a system and method for efficiently handling voltage level shifting. In various embodiments, a first level shifter receives a first isolate enable signal based on a first power supply voltage and a second isolate enable signal based on a second power supply voltage different from the first power supply voltage. A second level shifter generates the first isolate enable signal based on both the second isolate enable signal and the first power supply voltage. A circuit block generates a data signal based on the first power supply voltage. When it is determined that isolation for the first level shifter is enabled, the first level shifter generates a voltage level on an internal particular node to a particular voltage level based on the first isolate enable signal, and also prevents, using the second isolate enable signal, the data signal from setting a voltage level on the particular node.

Document US 2021/0294410 A1 discloses a circuit including a supply power detector in a first power domain and a ratioed inverter in the first power domain or a second, different power domain. The supply power detector includes an output coupled to an input of the ratioed inverter, and an output of the ratioed inverter provides a power sequencing signal for the second power domain.

Document US 2005/0035796 A1 discloses a semiconductor integrated circuit including an internal circuit, and a power-on reset circuit for generating a power-on reset signal to initialize the internal circuit at a power-on. At the power-on, the power-on reset circuit delays a transition of the power-on reset signal from a first level to a second level until a given time duration after the power supply voltage reaches a detection voltage.

### BRIEF SUMMARY OF THE INVENTION

A power level detection circuit according to the invention is defined in the independent claim 1. A two-stage power domain circuit comprising a power level detection circuit according to the invention is defined in the dependent claim 7. The further dependent claims define preferred embodiments thereof. The power level detection circuit according to the invention comprises a resistive circuit, a pull-up circuit, a pull-down circuit, and an output terminal. The resistive circuit is coupled between a first power terminal and a first node. The first power terminal is coupled to a first supply voltage. The pull-up circuit is coupled between a second power terminal and a second node. The second power terminal is coupled to a second supply voltage. The pull-down circuit is coupled between the second node and a common ground. The output terminal is coupled to the second node and configured to output a detection signal. The pull-up circuit and the pull-down circuit are configured to control a time point that the detection signal starts to transition from a first level to a second level according to the first supply voltage and the second supply voltage.

The two-stage power domain circuit comprises a first stage circuit, a second stage circuit, and a power level detection circuit as defined in any one of claims 1 to 6.

A detailed description is given in the following embodiments with reference to the accompanying drawings.

### BRIEF DESCRIPTION OF THE DRAWINGS

The present disclosure can be more fully understood by reading the subsequent detailed description and examples with references made to the accompanying drawings, wherein:
FIG. 1 shows one exemplary embodiment of a two-stage power domain circuit;
FIG. 2 shows another exemplary embodiment of a two-stage power domain circuit;
FIG. 3 shows one exemplary embodiment of a power level detection circuit;
FIG. 4 shows a timing chart of main signals of a two-stage power domain circuit according to an exemplary embodiment;
FIG. 5 shows another exemplary embodiment of a power level detection circuit;
FIG. 6 shows another exemplary embodiment of a power level detection circuit;
FIG. 7 shows another exemplary embodiment of a power level detection circuit;
FIG. 8 shows an exemplary embodiment of layout of a power level detection circuit; and
FIG. 9 shows another exemplary embodiment of a two-stage power domain circuit.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

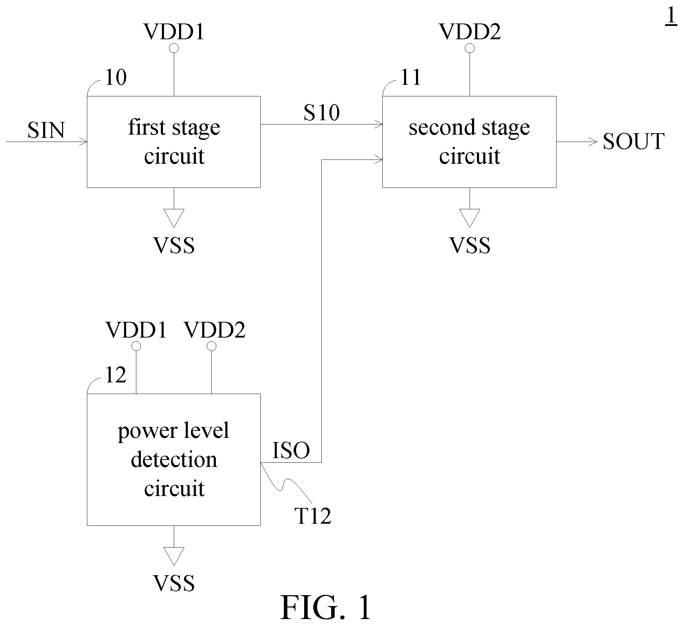

FIG. 1 shows an exemplary embodiment of a two-stage power domain circuit 1. Referring to FIG. 1, the two-stage power domain circuit 1 comprises a first stage circuit 10, a second stage circuit 11, and a power level detection circuit 12. The first stage circuit 10 operates in a first power domain and receives a supply voltage VDD1. The second stage circuit 11 operates in a second power domain that is different from the first power domain and receives a supply voltage VDD2. Both the first stage circuit 10 and the second stage circuit 11 are coupled to a common ground VSS.

The first stage circuit 10 receives an input signal SIN and performs a predetermined operation to generate an intermediate signal S10. The second stage circuit 11 receives the intermediate signal S10 and performs another predetermined operation to generate an output signal SOUT. The power level detection circuit 12 receives the supply voltages VDD1 and VDD2 and generates a detection signal ISO at an output terminal T12 of the power level detection circuit 12 according to the supply voltages VDD1 and VDD2. The detection signal ISO is utilized for indicating a variation of level of the supply voltage VDD1.

In a case where the supply voltage VDD2 is in an on state (that is, the level of the supply voltage VDD2 is on a predetermined high level), when the supply voltage VDD1 is in an off state (that is, the level of the supply voltage VDD1 is on a predetermined low level), the power level detection circuit 12 generates the detection signal ISO to cause the second stage circuit 11 to enter an isolation mode, thereby preventing a large crowbar current (that is, a short circuit current) between the power terminal of the supply voltage VDD2 and the common ground VSS. When the supply voltage VDD1 is switched to an on state (that is, the level of the supply voltage VDD1 is on a predetermined high level) from the off state, the power level detection circuit 12 generates the detection signal ISO to cause the second stage circuit 11 to enter a normal mode and perform the corresponding predetermined operation.

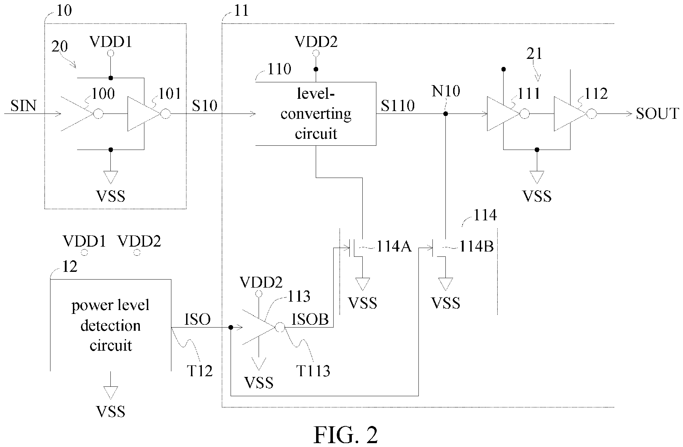

FIG. 2 shows another exemplary embodiment of the two-stage power domain circuit. In the embodiment of FIG. 2, the two-stage power domain circuit (such as, the two-stage power domain circuit 1 in FIG.1) operates as a level shifter. Referring to FIG. 2, the first stage circuit 10 comprises an input buffer 20 that receives the input signal SIN. Preferably, the input buffer 20 comprises inverters 100 and 101 coupled in series between the input terminal and the output terminal of the input buffer 20. Each of the inverters 100 and 101 is coupled to the common ground VSS and further receives the supply voltage VDD1. Based on the structure of the first stage circuit 10, the predetermined operation performed by the first stage circuit 10 is a buffering operation. The input buffer 20 performs the buffering operation on the input signal SIN to generate the intermediate signal S10.

The second stage circuit 11 comprises a level-converting circuit 110 (also called main circuit), an inverter 113, an isolation circuit 114, and an output buffer 21. Preferably, the predetermined operation performed by the second stage circuit 11 is a level converting operation. The level-converting circuit 110 receives the intermediate signal S10 and the supply voltage VDD2 and performs the level converting operation on the intermediate signal S10 according to the supply voltage VDD2 to generate a signal S110. The output buffer 21 is coupled to the level-converting circuit 110 at a node N10. The output buffer 21 comprises inverters 111 and 112 coupled in series between the input terminal (coupled to the node N10) and the output terminal of the output buffer 21. Each of the inverters 111 and 112 is coupled to the common ground VSS and further receives the supply voltage VDD2. The output buffer 21 performs a buffering operation on the signal S110 to generate the output signal SOUT.

The inverter 113 is coupled to the common ground VSS and further receives the supply voltage VDD2. The inverter 113 receives the detection signal ISO generated by the power level detection circuit 12. The inverter 113 inverts the phase of the detection signal IOS to generate another detection signal ISOB at an output terminal T113. In the embodiment, the inverter 113 is deployed in the second stage circuit 11. However, in other embodiments, the inverter 113 may be deployed in the power level detection circuit 12 or any other suitable circuit. In these embodiments, the output terminal T113 serves as another output terminal of the power level detection circuit 12 or the other suitable circuit.

The isolation circuit 114 comprises N-type metal-oxide-semiconductor (NMOS) transistors 114A and 114B. The drain of the NMOS transistor 114A is coupled to the level-converting circuit 110, the source thereof is coupled to the common ground VSS, and the gate thereof receives the detection signal ISOB. The drain of the NMOS transistor 114B is coupled to the node N10, the source thereof is coupled to the common ground VSS, and the gate thereof receives the detection signal ISO. The turned-on/turned-off states of the NMOS transistors 114A and 114B are controlled by the detection signals ISOB and ISO respectively.

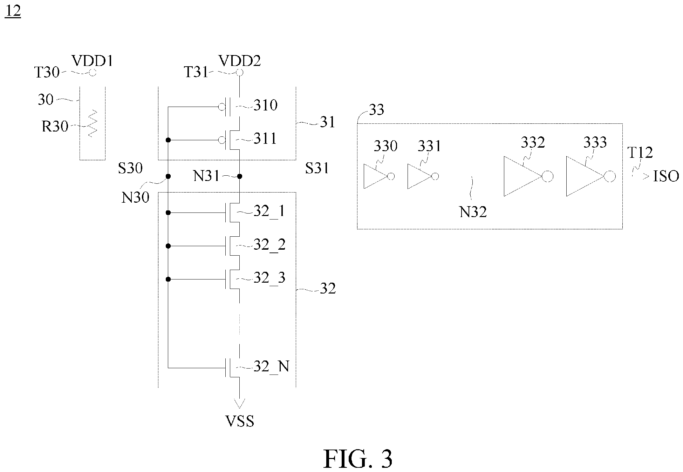

FIG. 3 shows an exemplary embodiment of the power level detection circuit 12. Referring to FIG. 3, the power level detection circuit 12 comprises a resistive circuit 30, a pull-up circuit 31, a pull-down circuit 32, and a delay chain circuit 33. Preferably, the resistive circuit 30 comprises a resistor R30. One terminal of the resistor R30 is coupled to a power terminal T30 to receive the supply voltage VDD1, and the other terminal thereof is coupled to a node N30. The examples of resistor R30 comprise but not limited to poly resistor, diffusion resistor, metal resistor, or Hi-R resistor, etc.

The pull-up circuit 31 is coupled between a power terminal T31 and a node N31. The pull-up circuit 31 receives the supply voltage VDD2 through the power terminal T31. The pull-up circuit 31 comprises a plurality of P-type metal-oxide-semiconductor (PMOS) transistors. Preferably, the pull-up circuit 31 comprising two PMOS transistors 310 and 311 is taken as an example. The PMOS transistors 310 and 311 are coupled in series between the power terminal T31 and the node N31. The gates of the PMOS transistors 310 and 311 are coupled to the node N30.

The pull-down circuit 32 is coupled between the node N31 and the common ground VSS. The pull-down circuit 32 comprises a plurality of NMOS transistors 32_1-32_N, wherein N is an integer. The NMOS transistors 32_1-32_N are coupled in series between the node N31 and the common ground VSS. The gates of the NMOS transistors 32_1-32_N are coupled to the node N30. Preferably, the number of PMOS transistors of the pull-up circuit 31 is less than the number of NMOS transistors of the pull-down circuit 32.

The input terminal of the delay chain circuit 33 is coupled to the node N31, and the output terminal thereof is coupled to the output terminal T12 of the power level detection circuit 12. The delay chain circuit 33 is configured to output the detection signal ISO. The delay chain circuit 33 comprises a plurality of inverters for generating the detection signal ISO according to the voltage signal S31 at the node N31. Preferably, the number of inverters in the delay chain circuit 33 is an even value. Referring to FIG. 3, the delay chain circuit 33 comprises four inverters, including two weak inverters 330 and 331 and two strong inverters 332 and 333. The weak inverters 330 and 331 are coupled in series between the node N31 and the node N32. The strong inverters 332 and 333 are coupled in series between the node N32 and the output terminal of the delay chain circuit 33, that is, the strong inverters 332 and 333 are coupled in series between the node N32 and the output terminal T32 of the power level detection circuit 12. In examples not forming part of the present invention, delay chain circuit 33 isn't necessary, and the output terminal is coupled to the node N31 directly. It should be noted that "strong inverter" and "weak inverter" are commonly used terms in the field of circuit design. They are often used to describe the characteristics and functions of inverter circuits, distinguishing differences such as drive capabilities, transmission delays, and power consumption of inverters. Generally, strong inverters have higher driving capabilities, lower transmission delays, and greater power consumption, while weak inverters have weaker driving capabilities, higher transmission delays, but lower power consumption.

In the following paragraphs, the operation of the power level detection circuit 12 is described by referring to FIGs. 2-4.

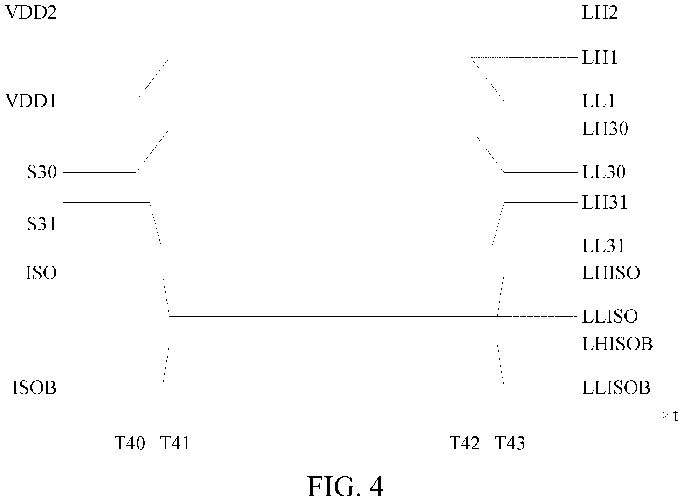

Assume that the supply voltage VDD2 is in an on state (that is, the level of the supply voltage VDD2 is on a predetermined high level LH2). Before the time point T40 shown in FIG. 4, the supply voltage VDD1 is in an off state (that is, the level of the supply voltage VDD1 is on a predetermined low level LL1). The voltage signal S30 at the node N30 is on a low level LL30 in response to the off state of the supply voltage VDD1. According to the voltage signal S30 with the low level LL30, the PMOS transistors 310 and 311 are turned on. The voltage signal S31 at the node N31 is on a high level LH31 according to the supply voltage VDD2 with the high level LH2. The inverters 330-333 of the delay chain circuit 33 receive the voltage signal S31 and delay the voltage signal S31 to make the detection signal ISO with a high level LHISO.

Referring to FIG. 2, the inverter 113 of the second stage circuit 11 inverts the phase of the detection signal ISO to make the detection signal ISOB with a low level LLISOB. The NMOS transistor 114A is turned off according to the detection signal ISOB with the low level LLISOB, and the NMOS transistor 114B is turned on according to the detection signal ISO with the high level LHISO. At this time, the second stage circuit 11 enters the isolation mode. Since the NMOS transistor 114A is turned off, the level-converting circuit 110 is isolated from the common ground VSS. Thus, no current path between the power terminal of the supply voltage VDD2 and the common ground VSS, thereby decreasing or eliminating crowbar current in the level-converting circuit 110. Moreover, the NMOS transistor 114B is turned on, and the node N10 is pull down to the common ground VSS, thereby decreasing or eliminating crowbar currents in the inverters 111 and 112.

At the time point T40, the supply voltage VDD1 starts increasing gradually. In response to the increased supply voltage VDD1, the voltage signal S30 increases gradually from the low level LL30. According to the increased voltage signal S30, the NMOS transistors 32_1-32_N are turned on, and the voltage signal S31 decreases gradually from the high level LH31. The inverters 330-333 of the delay chain circuit 33 receive the voltage signal S31 and delay the voltage signal S31 to make the detection signal ISO decrease gradually from the high level LHISO.

The time point (also referred to as a transition time point) when the detection signal ISO starts decreasing from the high level LHISO (that is, the time point that the detection signal ISO starts transition from the high level LHISO to the low level LHISO) is controlled by the ratio of the number of PMOS transistors of the pull-up circuit 31 to the number of NMOS transistors of the pull-down circuit 32 and further controlled by the operation characteristics of the weak inverters 330 and 331. Preferably, the lower ratio means the transition time point is later. Preferably, the above ratio and the operation characteristics of the weak inverters 330 and 331 are designed to cause the detection signal ISO to start decreasing from the high level LHISO after the supply voltage VDD1 increases from the low level LL1 to a half of the level difference between the high level LH1 and the low level LL1, this is only for illustrative purposes, and the present invention is not limited thereto.

The decreasing slope of the detection signal ISO is adjusted according to the operation characteristics of the strong inverters 332 and 333. In this disclosure, the decreasing slope and increasing slope is collectively called transition slope. In other words, the strong inverters 332 and 333 are configured to adjust the transition slope of the detection signal ISO.

Referring to FIG. 2, the inverter 113 inverts the phase of the detection signal ISO to generate the detection signal ISOB. When the detection signal ISO starts to decrease from the high level LHISO to the low level LLISO, the detection signal ISOB starts to increase gradually from the low level LLISOB to the high level LHISOB. The NMOS transistor 114A is turned on according to the increased detection signal ISOB, and the NMOS transistor 114B is turned off according to the decreased detection signal ISO. Thus, the level-converting circuit 110 and the output buffer 21 operate normally. In other words, the second stage circuit 11 enters the normal mode so that the second stage circuit 11 performs the level converting operation.

As described above, preferably, the detection signal ISO starts decreasing from the high level LHISO after the supply voltage VDD1 increases from the low level LL1 to a half of the level difference between the high level LH1 and the low level LL1, which may ensure that the second stage circuit 11 enters the normal mode after the intermediate signal S10 is stable (for example, reach to a predetermined high level or a predetermined low level ), thereby decreasing or eliminating crowbar current in the second stage circuit 11.

Preferably, the ratio of number of PMOS transistors of the pull-up circuit 31 to the number of NMOS transistors of the pull-down circuit 32 and the operation characteristics of the weak inverters 330 and 331 are designed or adjusted to delay the time point that the detection signal ISO starts decreasing (that is, transition) from the high level LHISO to the low level LLISO(or the time point that the detection signal ISOB starts increasing(that is, transition) from the low level LLISOB to the high level LHISOB) , in order to ensure that the NMOS transistor 114A is fully turned on after the intermediate signal S10 is stable, thereby decreasing or eliminating crowbar current in the second stage circuit 11. Furthermore, the operation characteristics of the strong inverters 332 and 333 are designed to make the decreasing slope of the detection signal ISO (or the increasing slope of the detection signal ISOB) fast enough, thereby further decreasing or eliminating crowbar current in the second stage circuit 11.

Referring to FIG. 4, at the time point T41, the supply voltage VDD1 reaches a high level LH1. In response to the supply voltage VDD1 with the high level LH1, the detection signal ISO reaches to a low level LLISO based on the operation of the power level detection circuit 12. The detection signal ISOB reaches a high level LHISOB. Thus, the NMOS transistor 114A is still turned on, and the NMOS transistor 114B is still turned off. Thus, the second stage circuit 11 is continuously in the normal mode.

At the time point T42, the supply voltage VDD1 starts decreasing gradually. In response to the decreased supply voltage VDD1, the voltage signal S30 decreases gradually from the high level LH30. According to the decreased voltage signal S30, the PMOS transistors 310 and 320 are turned on, and the voltage signal S31 increases gradually from the low level LL31. The inverters 330-333 of the delay chain circuit 33 receive the voltage signal S31 and delay the voltage signal S31 to make the detection signal ISO increase gradually from the low level LLISO.

Preferably, the time point (also referred to as a transition time point) when the detection signal ISO starts increasing (that is, transition) from the low level LLISO is controlled by the ratio of the number of number of PMOS transistors of the pull-up circuit 31 to the number of NMOS transistors of the pull-down circuit 32 and further controlled by the operation characteristics of the weak inverters 330 and 331. Preferably, the above ratio and the operation characteristics of the weak inverters 330 and 331 are designed to cause the detection signal ISO to start increasing from the low level LLISO after the supply voltage VDD1 decreases from the high level LH1 to a half of the level difference between the high level LH1 and the low level LL1, this is only for illustrative purposes, and the present invention is not limited thereto. The increasing slope of the detection signal ISO is adjusted according to the operation characteristics of the strong inverters 332 and 333.

Referring to FIG. 2, the inverter 113 inverts the phase of the detection signal ISO to generate the detection signal ISOB. When the detection signal ISO starts to increase from the low level LLISO to the high level LHISO, the detection signal ISOB starts to decrease gradually from the high level LHISOB to the low level LLISOB. The NMOS transistor 114A is turned off according to the decreased detection signal ISOB, and the NMOS transistor 114B is turned on according to the increased detection signal ISO. then, the second stage circuit 11 enters the isolation mode.

As described above, preferably, the detection signal ISO starts increasing from the low level LHISO after the supply voltage VDD1 decreases from the high level LH1 to a half of the level difference between the high level LH1 and the low level LL1, which may ensure that the second stage circuit 11 enters isolation mode after the intermediate signal S10 is stable (for example, reach to a predetermined high level or a predetermined low level ), thereby decreasing or eliminating crowbar current in the second stage circuit 11.

Preferably, the ratio of the number of PMOS transistors of the pull-up circuit 31 to the number of NMOS transistors of the pull-down circuit 32 and the operation characteristics of the weak inverters 330 and 331 are designed or adjusted to delay the time point that the detection signal ISO starts increasing (that is, transition) from the low level LLISO to the high level LHISO (or the time point that the detection signal ISOB starts decreasing (that is, transition) from the high level LHISOB to the low level LLISOB), in order to ensure that the NMOS transistor 114A is fully turned off after the intermediate signal S10 is stable, thereby decreasing or eliminating crowbar current in the second stage circuit 11. Furthermore, the operation characteristics of the strong inverters 332 and 333 are designed to make the increasing slope of the detection signal ISO (or the decreasing slope of the detection signal ISOB) fast enough, thereby further decreasing or eliminating crowbar current in the second stage circuit 11.

Referring to FIG. 4, at the time point T43, the supply voltage VDD1 reaches the low level LL1. In response to the supply voltage VDD1 with the low level LL1, the detection signal ISO reaches to the high level LHISO based on the operation of the power level detection circuit 12. The detection signal ISOB reaches the low level LLISOB. Thus, the NMOS transistor 114A is still turned off, and the NMOS transistor 114B is still turned on. Thus, the second stage circuit 11 is continuously in the isolation mode.

According to the above embodiments, the power level detection circuit 12 controls the second stage circuit 11 of the second power domain enters a normal mode or an isolation mode according to the variation of the supply voltage VDD1 of the first power domain, thereby decreasing or eliminating crowbar currents in the second stage circuit 11.

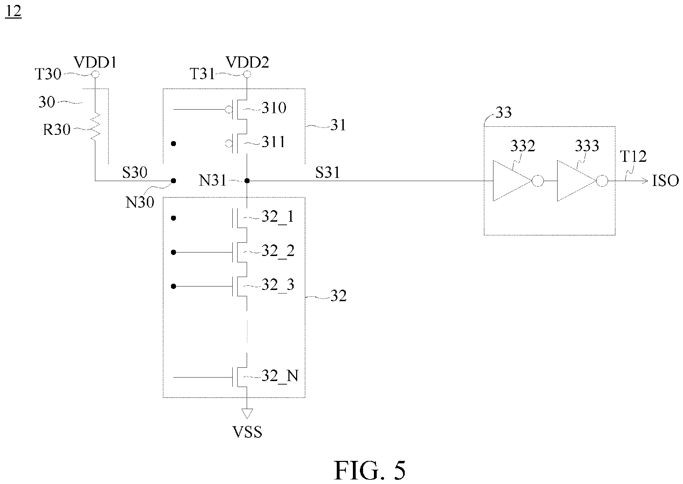

In the embodiment of FIG. 3, the delay chain circuit 33 comprises two weak inverters 330 and 331, and two strong inverters 332 and 333. In another embodiment, the delay chain circuit 33 comprises only strong inverters without any weak inverters. As shown in FIG. 5, the delay chain circuit 33 comprises two strong inverters 332 and 333 without any weak inverters.

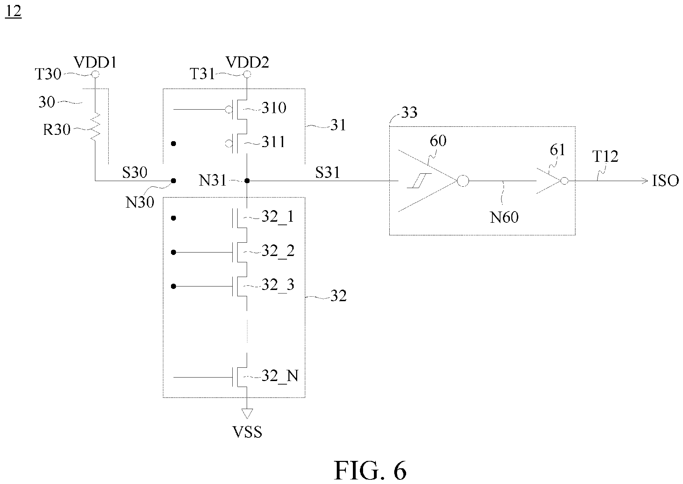

In another embodiment, the delay chain circuit 33 comprises a Schmitt trigger and at least one strong inverter. In this embodiment, the number of strong inverters is an odd value. Referring to FIG. 6, the delay chain circuit 33 comprises a Schmitt trigger 60 and a strong inverter 61. The Schmitt trigger 60 may delay the transition time point of the detection signal ISO/ISOB (that is, the time point that the detection signal ISO/ISOB starts transition from a high level to a low level or from a low level to a high level). Moreover, the Schmitt trigger 60 may filter the glitch on the voltage signal S31 that is induced by the glitch on the supply voltage VDD1.

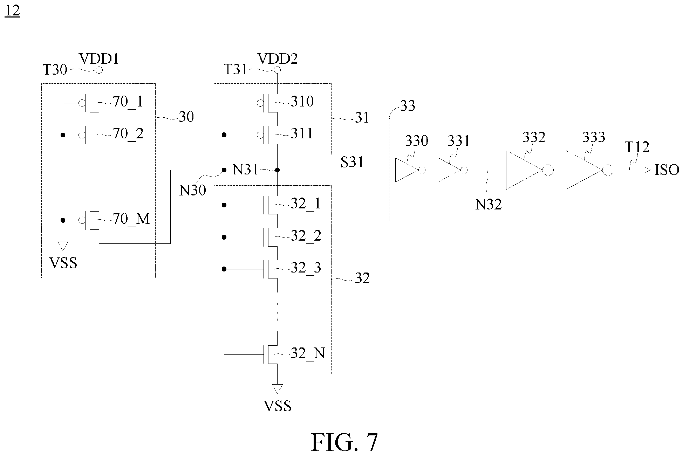

In the embodiment of FIG. 3, the resistive circuit 30 comprises a resistor R30. In another embodiment, as shown in FIG. 7, the resistive circuit 30 comprises a plurality of PMOS transistors 70_1-70_M coupled in series between the power terminal T30 and the node N30, wherein M is an integer. The gates of the PMOS transistors 70_1-70_M are coupled to the common ground VSS. Thus, the PMOS transistors 70_1-70_M are always turned on, which provides resistance.

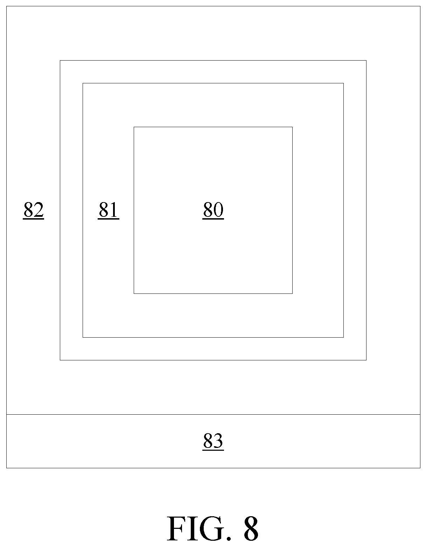

Preferably, the power level detection circuit 12 is implemented by a standard cell structure. FIG. 8 shows an exemplary embodiment of layout of a power level detection circuit. Referring to FIG. 8, a standard cell 8 comprises regions 80-82 and a bottom region 83. The resistive circuit 30 is formed in the region 80. The region 80 is surrounded by a region 81 where a guard ring is formed. The region 81 is surrounded by a region 82 where filter cells and/or boundary cells are formed. The PMOSs of the pull-up circuit 31, the NMOS transistors of the pull-down circuit 32, and the delay chain circuit 33 are formed in the bottom region 83.

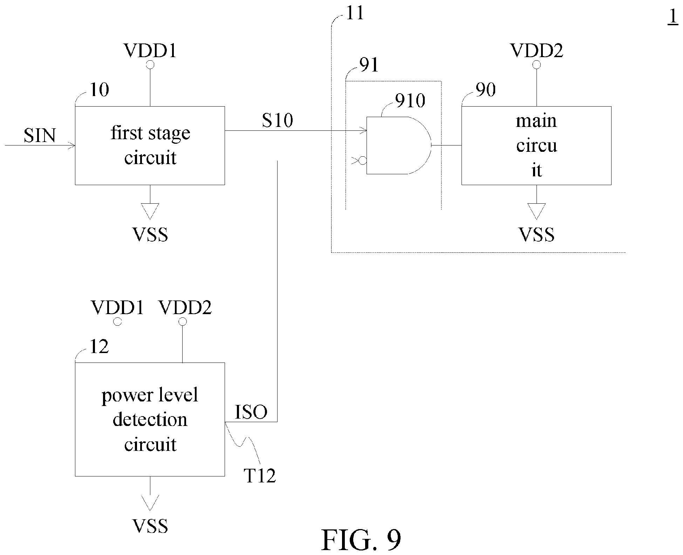

FIG. 9 shows another exemplary embodiment of the two-stage power domain circuit 1. Referring to FIG. 9, the second stage circuit 11 comprises a main circuit 90 and an isolation circuit 91. The main circuit 90 receives the supply voltage VDD2 and performs a predetermined operation according to the intermediate signal S10 to generate the output signal SOUT. The isolation circuit 91 is coupled between the first stage circuit 10 and the main circuit 90. The isolation circuit 91 receives the intermediate signal S10 and the detection signal ISO. The isolation circuit 91 determines whether the intermediate signal S10 is transmitted to the main circuit 90 according to the detection signal ISO.

Preferably, the isolation circuit 91 comprises an AND logic gate 910 that has a non-inverting input terminal receiving the intermediate signal S10, an inverting input terminal receiving the detection signal ISO, and an output terminal coupled to the main circuit 90. When the power level detection circuit 12 generates the detection signal ISO with the high level LHISO, the second stage circuit 11 enters the isolation mode. In details, according to the operation of the AND logic gate 910, the output signal of the AND logic gate 910 is not varied with the intermediate signal S10. That is, the main circuit 90 is isolated from the first stage circuit 10, and the intermediate signal S10 is not transmitted to the main circuit 90. Thereby decreasing or eliminating crowbar currents in the second stage circuit 11. When the power level detection circuit 12 generates the detection signal ISO with the low level LLISO, the second stage circuit 11 enters the normal mode. In details, according to the operation of the AND logic gate 910, the output signal of the AND logic gate 910 varies with the intermediate signal S10, that is, the intermediate signal S10 is transmitted to the main circuit 90, and the main circuit 90 normally operates to perform the predetermined operation according to the intermediate signal S10. Thereby decreasing or eliminating crowbar currents in the second stage circuit 11. In this embodiment, AND logic gate 910 is only used for illustration purpose, alternatively it could be replaced by other logic circuits. The operations of the power level detection circuit 12 in this embodiment are described above, for the sake of simplicity, further elaboration is omitted here.

While the present disclosure has been described by way of example and in terms of the preferred embodiments, it is to be understood that the invention is not limited to the disclosed embodiments. To the contrary, it is intended to cover various modifications and similar arrangements, as defined by the appended claims.

## Claims

1. A power level detection circuit (12) comprising:
a resistive circuit (30), coupled between a first power terminal (T30) and a first node (N30), wherein the first power terminal (T30) is coupled to a first supply voltage (VDD1);
a pull-up circuit (31), coupled between a second power terminal (T31) and a second node (N31), wherein the second power terminal (T31) is coupled to a second supply voltage (VDD2);
a pull-down circuit (32), coupled between the second node (N31) and a common ground (VSS); and
an output terminal (T12), coupled to the second node (N31), and configured to output a detection signal (ISO),
wherein the pull-up circuit (31) and the pull-down circuit (32) are configured to control a time point that the detection signal (ISO) starts to transition from a first level to a second level according to the first supply voltage (VDD1) and the second supply voltage (VDD2);
**characterized by**:
a delay chain circuit (33) coupled between the second node (N31) and the output terminal (T12), comprising at least one strong inverter (332, 333; 61),
wherein the at least one strong inverter (332, 333; 61) is configured to increase a transition slope of the detection signal (ISO).

2. The power level detection circuit (12) as claimed in claim 1, wherein the delay chain circuit (33) further comprises:
at least one weak inverter (330, 331) coupled between the second node (N31) and the at least one strong inverter (332, 333), configured to control the time point that the detection signal (ISO) starts to transition from the first level to the second level together with the pull-up circuit (31) and the pull-down circuit (32);
wherein preferably the at least one weak inverter (330, 331), the pull-up circuit (31) and the pull-down circuit (32) are configured to delay the time point that the detection signal (ISO) starts to transition from the first level to the second level.

3. The power level detection circuit (12) as claimed in claim 1, wherein the delay chain circuit (33) further comprises:
a Schmitt trigger (60) coupled between the second node (N31) and the at least one strong inverter (61), configured to control the time point that the detection signal (ISO) starts to transition from the first level to the second level together with the pull-up circuit (31) and the pull-down circuit (32);
wherein preferably the Schmitt trigger (60), the pull-up circuit (31) and the pull-down circuit (32) are configured to delay the time point that the detection signal (ISO) starts to transition from the first level to the second level.

4. The power level detection circuit (12) as claimed in any one of claims 1 to 3, wherein the pull-up circuit (31) comprises:
a plurality of P-type metal-oxide-semiconductor, in the following also referred to as PMOS, transistors (310, 311) coupled in series between the second power terminal (T31) and the second node (N31),
wherein gates of the plurality of PMOS transistors (310, 311) are coupled to the first node (N30), and
wherein the pull-down circuit (32) comprises:
a plurality of N-type metal-oxide-semiconductor, in the following also referred to as NMOS, transistors (32_1 ... 32_N) coupled in series between the second node (N31) and the common ground (VSS),
wherein gates of the plurality of NMOS transistors (32_1 ... 32_N) are coupled to the first node (N30), and
wherein a ratio of the number of plurality of PMOS transistors (310, 311) of the pull-up circuit (31) to the number of plurality of NMOS transistors (32_1 ... 32_N) of the pull-down circuit (32) is configured to delay the time point that the detection signal (ISO) starts transition from the first level to the second level.

5. The power level detection circuit (12) as claimed in any one of claims 1 to 4, wherein the output terminal (T12) is a first output terminal, and the detection signal (ISO) is a first detection signal, wherein the power level detection circuit (12) further comprises:
a second output terminal (T113), configured to output a second detection signal (ISOB); and
an inverter (113), coupled between the second node (N31) and the second output terminal (T113), and configured to output the second detection signal (ISOB).

6. The power level detection circuit (12) as claimed in any one of claims 1 to 5, wherein the power level detection circuit (12) is implemented by a standard cell structure.

7. A two-stage power domain circuit (1) comprises:
a first stage circuit (10) operating in a first power domain, configured to receive an input signal (SIN) and generate an intermediate signal (S10);
a second stage circuit (11) operating in a second power domain, configured to receive the intermediate signal (S10) and generate an output signal (SOUT); and
a power level detection circuit (12) according to any one of claims 1 to 6, wherein the first supply voltage (VDD1) is a supply voltage of the first power domain and the second supply voltage (VDD2) is a supply voltage of the second power domain.

8. The two-stage power domain circuit (1) as claimed in claim 7, wherein the second stage circuit (11) comprises:
a main circuit (110), configured to receive the second supply voltage (VDD2) and the intermediate signal (S10) and perform a predetermined operation according to the intermediate signal (S10) to generate a first signal (S110) at a first node (N10);
an output buffer (21), configured to receive the first signal (S110) and generate the output signal (SOUT); and
an isolation circuit (114), configured to receive the first detection signal (ISO) and a second detection signal (ISOB) inverse to the first detection signal (ISO), and to control whether a first path between the main circuit (110) and a common ground (VSS) is cut off according to the second detection signal (ISOB), and to control whether a second path between the first node (N10) and the common ground (VSS) is cut off according to the first detection signal (ISO).

9. The two-stage power domain circuit (1) as claimed in claim 8, wherein the second stage circuit (11) further comprises:
an inverter (113), coupled between the power level detection circuit (12) and the isolation circuit (114), and configured to output the second detection signal (ISOB) according to the first detection signal (ISO).

10. The two-stage power domain circuit (1) as claimed in claim 8 or 9, wherein the isolation circuit (114) comprises:
a first transistor (114A) having a first terminal coupled to the main circuit (110), a second terminal coupled to the common ground (VSS), and a third terminal configured to receive the second detection signal (ISOB); and
a second transistor (114B) having a first terminal coupled to the first node (N10), a second terminal coupled to the common ground (VSS), and a third terminal configured to receive the first detection signal (ISO).

11. The two-stage power domain circuit (1) as claimed in claim 7, wherein the second stage circuit (11) further comprises:
a main circuit (90), configured to receive the second supply voltage (VDD2) and perform a predetermined operation according to the intermediate signal (S10) to generate the output signal (SOUT); and
an isolation circuit (91), coupled between the first stage circuit (10) and the main circuit (90), configured to receive the intermediate signal (S10) and the first detection signal (ISO),
wherein the isolation circuit (91) is further configured to determine whether the intermediate signal (S10) is transmitted to the main circuit (90) according to the first detection signal (ISO).

12. The two-stage power domain (1) circuit as claimed in claim 11, wherein the isolation circuit (91) comprises:
an AND logic gate (910) having a non-inverting input terminal configured to receive the intermediate signal (S10), an inverting input terminal configured to receive the first detection signal (ISO), and an output terminal coupled to the main circuit (90).

## Patentansprüche

1. Leistungspegelerfassungsschaltung (12), umfassend:
eine Widerstandsschaltung (30), die zwischen einen ersten Leistungsanschluss (T30) und einen ersten Knoten (N30) gekoppelt ist, wobei der erste Leistungsanschluss (T30) mit einer ersten Versorgungsspannung (VDD1) gekoppelt ist;
eine Pull-up-Schaltung (31), die zwischen einen zweiten Leistungsanschluss (T31) und einen zweiten Knoten (N31) gekoppelt ist, wobei der zweite Leistungsanschluss (T31) mit einer zweiten Versorgungsspannung (VDD2) gekoppelt ist;
eine Pull-down-Schaltung (32), die zwischen den zweiten Knoten (N31) und eine gemeinsame Masse (VSS) gekoppelt ist; und
einen Ausgangsanschluss (T12), der mit dem zweiten Knoten (N31) gekoppelt ist und konfiguriert ist, um ein Erfassungssignal (ISO) auszugeben,
wobei die Pull-up-Schaltung (31) und die Pull-down-Schaltung (32) konfiguriert sind, um einen Zeitpunkt zu steuern, zu dem das Erfassungssignal (ISO) gemäß der ersten Versorgungsspannung (VDD1) und der zweiten Versorgungsspannung (VDD2) beginnt, von einem ersten Pegel zu einem zweiten Pegel überzugehen;
**gekennzeichnet durch**:
eine Verzögerungskettenschaltung (33), die zwischen den zweiten Knoten (N31) und den Ausgangsanschluss (T12) gekoppelt ist, umfassend mindestens einen starken Wechselrichter (332, 333; 61),
wobei der mindestens eine starke Wechselrichter (332, 333; 61) konfiguriert ist, um eine Übergangssteilheit des Erfassungssignals (ISO) zu erhöhen.

2. Leistungspegelerfassungsschaltung (12) nach Anspruch 1, wobei die Verzögerungskettenschaltung (33) ferner umfasst:
mindestens einen schwachen Wechselrichter (330, 331), der zwischen den zweiten Knoten (N31) und den mindestens einen starken Wechselrichter (332, 333) gekoppelt ist und konfiguriert ist, um zusammen mit der Pull-up-Schaltung (31) und der Pull-down-Schaltung (32) den Zeitpunkt zu steuern, zu dem das Erfassungssignal (ISO) beginnt, von dem ersten Pegel zu dem zweiten Pegel überzugehen;
wobei vorzugsweise der mindestens eine schwache Wechselrichter (330, 331), die Pull-up-Schaltung (31) und die Pull-down-Schaltung (32) konfiguriert sind, um den Zeitpunkt zu verzögern, zu dem das Erfassungssignal (ISO) beginnt, von dem ersten Pegel zu dem zweiten Pegel überzugehen.

3. Leistungspegelerfassungsschaltung (12) nach Anspruch 1, wobei die Verzögerungskettenschaltung (33) ferner umfasst:
einen Schmitt-Trigger (60), der zwischen den zweiten Knoten (N31) und den mindestens einen starken Wechselrichter (61) gekoppelt ist und konfiguriert ist, um zusammen mit der Pull-up-Schaltung (31) und der Pull-down-Schaltung (32) den Zeitpunkt zu steuern, zu dem das Erfassungssignal (ISO) beginnt, von dem ersten Pegel zu dem zweiten Pegel überzugehen;
wobei vorzugsweise der Schmitt-Trigger (60), die Pull-up-Schaltung (31) und die Pull-down-Schaltung (32) konfiguriert sind, um den Zeitpunkt zu verzögern, zu dem das Erfassungssignal (ISO) beginnt, von dem ersten Pegel zu dem zweiten Pegel überzugehen.

4. Leistungspegelerfassungsschaltung (12) nach einem der Ansprüche 1 bis 3, wobei die Pull-up-Schaltung (31) umfasst:
eine Vielzahl von P-Typ-Metalloxid-Halbleiter-, im Folgenden auch als PMOS bezeichnet, Transistoren (310, 311), die in Reihe zwischen den zweiten Leistungsanschluss (T31) und den zweiten Knoten (N31) gekoppelt sind,
wobei Gates der Vielzahl von PMOS-Transistoren (310, 311) mit dem ersten Knoten (N30) gekoppelt sind, und
wobei die Pull-down-Schaltung (32) umfasst:
eine Vielzahl von N-Typ-Metalloxid-Halbleiter-, im Folgenden auch als NMOS bezeichnet, Transistoren (32_1 ... 32_N), die in Reihe zwischen den zweiten Knoten (N31) und die gemeinsame Masse (VSS) gekoppelt sind,
wobei Gates der Vielzahl von NMOS-Transistoren (32_1 ... 32_N) mit dem ersten Knoten (N30) gekoppelt sind, und
wobei ein Verhältnis der Anzahl der Vielzahl von PMOS-Transistoren (310, 311) der Pull-up-Schaltung (31) zu der Anzahl der Vielzahl von NMOS-Transistoren (32_1 ... 32_N) der Pull-down-Schaltung (32) konfiguriert ist, um den Zeitpunkt zu verzögern, zu dem das Erfassungssignal (ISO) beginnt, von dem ersten Pegel zu dem zweiten Pegel überzugehen.

5. Leistungspegelerfassungsschaltung (12) nach einem der Ansprüche 1 bis 4, wobei der Ausgangsanschluss (T12) ein erster Ausgangsanschluss ist und das Erfassungssignal (ISO) ein erstes Erfassungssignal ist, wobei die Leistungspegelerfassungsschaltung (12) ferner umfasst:
einen zweiten Ausgangsanschluss (T113), der konfiguriert ist, um ein zweites Erfassungssignal (ISOB) auszugeben; und
einen Wechselrichter (113), der zwischen den zweiten Knoten (N31) und den zweiten Ausgangsanschluss (T113) gekoppelt ist und konfiguriert ist, um das zweite Erfassungssignal (ISOB) auszugeben.

6. Leistungspegelerfassungsschaltung (12) nach einem der Ansprüche 1 bis 5, wobei die Leistungspegelerfassungsschaltung (12) durch eine Standardzellenstruktur implementiert ist.

7. Zweistufige Leistungsbereichsschaltung (1), umfassend:
eine erste Stufenschaltung (10), die in einem ersten Leistungsbereich arbeitet und konfiguriert ist, um ein Eingangssignal (SIN) zu empfangen und ein Zwischensignal (S10) zu erzeugen;
eine zweite Stufenschaltung (11), die in einem zweiten Leistungsbereich arbeitet und konfiguriert ist, um das Zwischensignal (S10) zu empfangen und ein Ausgangssignal (SOUT) zu erzeugen; und
eine Leistungspegelerfassungsschaltung (12) nach einem der Ansprüche 1 bis 6, wobei die erste Versorgungsspannung (VDD1) eine Versorgungsspannung des ersten Leistungsbereichs ist und die zweite Versorgungsspannung (VDD2) eine Versorgungsspannung des zweiten Leistungsbereichs ist.

8. Zweistufige Leistungsbereichsschaltung (1) nach Anspruch 7, wobei die zweite Stufenschaltung (11) umfasst:
eine Hauptschaltung (110), die konfiguriert ist, um die zweite Versorgungsspannung (VDD2) und das Zwischensignal (S10) zu empfangen und eine vorbestimmte Operation gemäß dem Zwischensignal (S10) durchzuführen, um ein erstes Signal (S110) an einem ersten Knoten (N10) zu erzeugen;
einen Ausgangspuffer (21), der konfiguriert ist, um das erste Signal (S110) zu empfangen und das Ausgangssignal (SOUT) zu erzeugen; und
eine Isolationsschaltung (114), die konfiguriert ist, um das erste Erfassungssignal (ISO) und ein zweites Erfassungssignal (ISOB), das zu dem ersten Erfassungssignal (ISO) invers ist, zu empfangen und gemäß dem zweiten Erfassungssignal (ISOB) zu steuern, ob ein erster Pfad zwischen der Hauptschaltung (110) und einer gemeinsamen Masse (VSS) unterbrochen ist, und gemäß dem ersten Erfassungssignal (ISO) zu steuern, ob ein zweiter Pfad zwischen dem ersten Knoten (N10) und der gemeinsamen Masse (VSS) unterbrochen ist.

9. Zweistufige Leistungsbereichsschaltung (1) nach Anspruch 8, wobei die zweite Stufenschaltung (11) ferner umfasst:
einen Wechselrichter (113), der zwischen die Leistungspegelerfassungsschaltung (12) und die Isolationsschaltung (114) gekoppelt ist und konfiguriert ist, um das zweite Erfassungssignal (ISOB) gemäß dem ersten Erfassungssignal (ISO) auszugeben.

10. Zweistufige Leistungsbereichsschaltung (1) nach Anspruch 8 oder 9, wobei die Isolationsschaltung (114) umfasst:
einen ersten Transistor (114A) mit einem ersten Anschluss, der mit der Hauptschaltung (110) gekoppelt ist, einem zweiten Anschluss, der mit der gemeinsamen Masse (VSS) gekoppelt ist, und einem dritten Anschluss, der konfiguriert ist, um das zweite Erfassungssignal (ISOB) zu empfangen; und
einen zweiten Transistor (114B) mit einem ersten Anschluss, der mit dem ersten Knoten (N10) gekoppelt ist, einem zweiten Anschluss, der mit der gemeinsamen Masse (VSS) gekoppelt ist, und einem dritten Anschluss, der konfiguriert ist, um das erste Erfassungssignal (ISO) zu empfangen.

11. Zweistufige Leistungsbereichsschaltung (1) nach Anspruch 7, wobei die zweite Stufenschaltung (11) ferner umfasst:
eine Hauptschaltung (90), die konfiguriert ist, um die zweite Versorgungsspannung (VDD2) zu empfangen und eine vorbestimmte Operation gemäß dem Zwischensignal (S10) durchzuführen, um das Ausgangssignal (SOUT) zu erzeugen; und
eine Isolationsschaltung (91), die zwischen die erste Stufenschaltung (10) und die Hauptschaltung (90) gekoppelt ist und konfiguriert ist, um das Zwischensignal (S10) und das erste Erfassungssignal (ISO) zu empfangen,
wobei die Isolationsschaltung (91) ferner konfiguriert ist, um gemäß dem ersten Erfassungssignal (ISO) zu bestimmen, ob das Zwischensignal (S10) an die Hauptschaltung (90) übertragen wird.

12. Zweistufige Leistungsbereichsschaltung (1) nach Anspruch 11, wobei die Isolationsschaltung (91) umfasst:
ein UND-Logikgatter (910) mit einem nicht invertierenden Eingangsanschluss, der konfiguriert ist, um das Zwischensignal (S10) zu empfangen, einem invertierenden Eingangsanschluss, der konfiguriert ist, um das erste Erfassungssignal (ISO) zu empfangen, und einem Ausgangsanschluss, der mit der Hauptschaltung (90) gekoppelt ist.

## Revendications

1. Circuit de détection de niveau de puissance (12) comprenant :
un circuit résistif (30), couplé entre une première borne de puissance (T30) et un premier noeud (N30), dans lequel la première borne de puissance (T30) est couplée à une première tension d'alimentation (VDD1) ;
un circuit d'excursion haute (31), couplé entre une seconde borne de puissance (T31) et un second noeud (N31), dans lequel la seconde borne de puissance (T31) est couplée à une seconde tension d'alimentation (VDD2) ;
un circuit d'excursion basse (32), couplé entre le second noeud (N31) et une masse commune (VSS) ; et
une borne de sortie (T12), couplée au second noeud (N31), et configurée pour délivrer en sortie un signal de détection (ISO),
dans lequel le circuit d'excursion haute (31) et le circuit d'excursion basse (32) sont configurés pour commander un point temporel auquel le signal de détection (ISO) commence à passer d'un premier niveau à un second niveau selon la première tension d'alimentation (VDD1) et la seconde tension d'alimentation (VDD2) ;
**caractérisé par** :
un circuit de chaîne de retard (33) couplé entre le second noeud (N31) et la borne de sortie (T12), comprenant au moins un inverseur fort (332, 333 ; 61),
dans lequel l'au moins un inverseur fort (332, 333 ; 61) est configuré pour augmenter une pente de transition du signal de détection (ISO).

2. Circuit de détection de niveau de puissance (12) selon la revendication 1, dans lequel le circuit de chaîne de retard (33) comprend en outre :
au moins un inverseur faible (330, 331) couplé entre le second noeud (N31) et l'au moins un inverseur fort (332, 333), configuré pour commander le point temporel auquel le signal de détection (ISO) commence à passer du premier niveau au second niveau conjointement avec le circuit d'excursion haute (31) et le circuit d'excursion basse (32) ;
dans lequel de préférence l'au moins un inverseur faible (330, 331), le circuit d'excursion haute (31) et le circuit d'excursion basse (32) sont configurés pour retarder le point temporel auquel le signal de détection (ISO) commence à passer du premier niveau au second niveau.

3. Circuit de détection de niveau de puissance (12) selon la revendication 1, dans lequel le circuit de chaîne de retard (33) comprend en outre :
un déclencheur de Schmitt (60) couplé entre le second noeud (N31) et l'au moins un inverseur fort (61), configuré pour commander le point temporel auquel le signal de détection (ISO) commence à passer du premier niveau au second niveau conjointement avec le circuit d'excursion haute (31) et le circuit d'excursion basse (32) ;
dans lequel de préférence le déclencheur de Schmitt (60), le circuit d'excursion haute (31) et le circuit d'excursion basse (32) sont configurés pour retarder le point temporel auquel le signal de détection (ISO) commence à passer du premier niveau au second niveau.

4. Circuit de détection de niveau de puissance (12) selon l'une quelconque des revendications 1 à 3, dans lequel le circuit d'excursion haute (31) comprend :
une pluralité de transistors métal-oxyde-semiconducteur de type P, ci-après également appelés PMOS, (310, 311) couplés en série entre la seconde borne de puissance (T31) et le second noeud (N31),
dans lequel des grilles de la pluralité de transistors PMOS (310, 311) sont couplées au premier noeud (N30), et
dans lequel le circuit d'excursion basse (32) comprend :
une pluralité de transistors métal-oxyde-semiconducteur de type N, ci-après également appelés NMOS, (32_1 ... 32_N) couplés en série entre le second noeud (N31) et la masse commune (VSS),
dans lequel des grilles de la pluralité de transistors NMOS (32_1 ... 32_N) sont couplées au premier noeud (N30), et
dans lequel un rapport du nombre de la pluralité de transistors PMOS (310, 311) du circuit d'excursion haute (31) sur le nombre de la pluralité de transistors NMOS (32_1 ... 32_N) du circuit d'excursion basse (32) est configuré pour retarder le point temporel auquel le signal de détection (ISO) commence à passer du premier niveau au second niveau.

5. Circuit de détection de niveau de puissance (12) selon l'une quelconque des revendications 1 à 4, dans lequel la borne de sortie (T12) est une première borne de sortie, et le signal de détection (ISO) est un premier signal de détection, dans lequel le circuit de détection de niveau de puissance (12) comprend en outre :
une seconde borne de sortie (T113), configurée pour délivrer en sortie un second signal de détection (ISOB) ; et
un inverseur (113), couplé entre le second noeud (N31) et la seconde borne de sortie (T113), et configuré pour délivrer en sortie le second signal de détection (ISOB).

6. Circuit de détection de niveau de puissance (12) selon l'une quelconque des revendications 1 à 5, dans lequel le circuit de détection de niveau de puissance (12) est mis en œuvre par une structure de cellule standard.

7. Circuit de domaine de puissance à deux étages (1) comprenant :
un premier circuit d'étage (10) fonctionnant dans un premier domaine de puissance, configuré pour recevoir un signal d'entrée (SIN) et générer un signal intermédiaire (S10) ;
un second circuit d'étage (11) fonctionnant dans un second domaine de puissance, configuré pour recevoir le signal intermédiaire (S10) et générer un signal de sortie (SOUT) ; et
un circuit de détection de niveau de puissance (12) selon l'une quelconque des revendications 1 à 6, dans lequel la première tension d'alimentation (VDD1) est une tension d'alimentation du premier domaine de puissance et la seconde tension d'alimentation (VDD2) est une tension d'alimentation du second domaine de puissance.

8. Circuit de domaine de puissance à deux étages (1) selon la revendication 7, dans lequel le second circuit d'étage (11) comprend :
un circuit principal (110), configuré pour recevoir la seconde tension d'alimentation (VDD2) et le signal intermédiaire (S10) et effectuer une opération prédéterminée selon le signal intermédiaire (S10) pour générer un premier signal (S110) au niveau d'un premier noeud (N10) ;
un tampon de sortie (21), configuré pour recevoir le premier signal (S110) et générer le signal de sortie (SOUT) ; et
un circuit d'isolation (114), configuré pour recevoir le premier signal de détection (ISO) et un second signal de détection (ISOB) inverse au premier signal de détection (ISO), et pour commander si un premier chemin entre le circuit principal (110) et une masse commune (VSS) est coupé selon le second signal de détection (ISOB), et pour commander si un second chemin entre le premier noeud (N10) et la masse commune (VSS) est coupé selon le premier signal de détection (ISO).

9. Circuit de domaine de puissance à deux étages (1) selon la revendication 8, dans lequel le second circuit d'étage (11) comprend en outre :
un inverseur (113), couplé entre le circuit de détection de niveau de puissance (12) et le circuit d'isolation (114), et configuré pour délivrer en sortie le second signal de détection (ISOB) selon le premier signal de détection (ISO).

10. Circuit de domaine de puissance à deux étages (1) selon la revendication 8 ou 9, dans lequel le circuit d'isolation (114) comprend :
un premier transistor (114A) ayant une première borne couplée au circuit principal (110), une deuxième borne couplée à la masse commune (VSS), et une troisième borne configurée pour recevoir le second signal de détection (ISOB) ; et
un second transistor (114B) ayant une première borne couplée au premier noeud (N10), une deuxième borne couplée à la masse commune (VSS), et une troisième borne configurée pour recevoir le premier signal de détection (ISO).

11. Circuit de domaine de puissance à deux étages (1) selon la revendication 7, dans lequel le second circuit d'étage (11) comprend en outre :
un circuit principal (90), configuré pour recevoir la seconde tension d'alimentation (VDD2) et effectuer une opération prédéterminée selon le signal intermédiaire (S10) pour générer le signal de sortie (SOUT) ; et
un circuit d'isolation (91), couplé entre le premier circuit d'étage (10) et le circuit principal (90), configuré pour recevoir le signal intermédiaire (S10) et le premier signal de détection (ISO),
dans lequel le circuit d'isolation (91) est en outre configuré pour déterminer si le signal intermédiaire (S10) est transmis au circuit principal (90) selon le premier signal de détection (ISO).

12. Circuit de domaine de puissance à deux étages (1) selon la revendication 11, dans lequel le circuit d'isolation (91) comprend :
une porte logique ET (910) ayant une borne d'entrée non inverseuse configurée pour recevoir le signal intermédiaire (S10), une borne d'entrée inverseuse configurée pour recevoir le premier signal de détection (ISO), et une borne de sortie couplée au circuit principal (90).
